# EUROPÄISCHE PATENTANMELDUNG

(11) **EP 3 403 752 A1**
(43) Veröffentlichungstag der Anmeldung: **21.11.2018**
(21) Anmeldenummer: 17171752.3
(22) Anmeldetag: 18.05.2017
(51) Int. Cl.: B23D 19/06, B26D 1/24, C23C 14/06

(54) **WERKZEUG ZUM SPALTEN VON ALUMINIUMBAND UND VERFAHREN ZUR HERSTELLUNG EINES SOLCHEN WERKZEUGS**

(71) Anmelder: Becker Stahl-Service GmbH, 59199 Bönen (DE)
(72) Erfinder: PÖTTCKER, Michael, 33449 Langenberg (DE); STANDERA, Karl, 58093 Hagen (DE); SCHAMP, Simon, 58675 Hemer (DE)
(74) Vertreter: Patentanwälte Dörner & Kötter PartG mbB

(57) **Zusammenfassung**

Die Erfindung betrifft ein Werkzeug zum Spalten von Aluminiumband, welches eine ringförmige Gestalt hat und aus einem Edelstahl besteht, der poliert ist. Auf den Edelstahl ist eine reibungsmindernde Beschichtung aufgebracht. Die Erfindung betrifft weiterhin Verfahren zur Herstellung eines Werkzeugs zum Spalten von Aluminiumband.

## Beschreibung

Die Erfindung betrifft ein Werkzeug zum Spalten von Aluminiumband, welches eine ringförmige Gestalt hat und aus einem Edelstahl besteht, der poliert ist. Die Erfindung betrifft außerdem ein Verfahren zur Herstellung eines solchen Werkzeugs.

Gewalztes Metallband wird aus wirtschaftlichen Gründen möglichst breit gewalzt und anschließend in Bandstreifen gewünschter Breite längsgeteilt. Diese Bandstreifen werden ihrerseits aufgehaspelt und als schmale Coils zum Versand und zur Weiterverarbeitung bereitgehalten. Das Längsteilen wird üblicherweise als "Spalten" bezeichnet.

Beim Spalten von Stahl- oder Aluminiumband wird das zu spaltende Material nicht in voller Dicke geschnitten, sondern es erfolgt lediglich ein teilweiser Anschnitt. Durch diesen Anschnitt wird das verbleibende Material gebrochen. Als Werkzeuge, auch "Messer" genannt, kommen kreisrunde, rotierende Ringe zur Anwendung, die auf übereinander und in einem Gerüst angeordneten Wellen vorgesehen sind und die in horizontaler Richtung versetzt zueinander positioniert sind. Der dadurch zwischen den Ringen in horizontaler Richtung hervorgerufene Abstand wird als "Schnittluft" bezeichnet. Die Messer sind zudem auf den übereinander vorgesehenen Wellen derart angeordnet, dass auch in vertikaler Richtung zwischen den Messern ein Abstand hervorgerufen ist, der geringer ist, als die Stärke bzw. Dicke des zu spaltenden Materials. In Bezug auf den vertikalen Abstand der Messer spricht man von "Überlappung"; die Differenz zwischen Materialstärke und vertikalem Abstand der Messer wird als "Eintauchtiefe" bezeichnet.

Ziel beim Spalten des Bandes ist, dass der Materialbruch von der Schnittkante des oberen Messers parallel mit der Bruchkante des unteren Messers verläuft. Diese Bruchkante wird "Scherebene" genannt. Soweit diese Bruchkanten oder auch die Schnittebene nicht zueinander parallel verlaufen, können Schnittgrate und andere Probleme entstehen, was die Qualität des Bandes reduziert. Dies beeinflusst nachfolgende sekundäre Verarbeitungsverfahren negativ. Für einen optimalen Schnitt ist die Abstimmung von Schnittluft in Bezug auf die Eintauchtiefe in das Material von großer Bedeutung, um den benötigten Bruch zu erzielen.

Zum Spalten des Bandes werden Messer aus Stahl eingesetzt. Es kommen stoßfeste Stähle mit großer Zähigkeit, die einem geringen Verschleiß unterliegen, ebenso zur Anwendung wie hochlegierte Stähle mit geringerer Zähigkeit und damit höherem Verschleiß. Die Auswahl des Messermaterials hängt von der jeweiligen Anwendung ab, also beispielsweise vom Material des zu spaltenden Bandes und der Materialstärke.

Das Spalten von Stahlband erfolgt trocken. Das bedeutet, dass die Messer und das Stahlband ohne Verwendung von Schmiermitteln unmittelbar miteinander in Kontakt stehen. Auch ohne Schmierung kommt es zu einem sauberen Schnitt mit einer glatten Schnittkante. Dies hat seine Ursache in der hohen Materialfestigkeit von Stahl, so dass es beim Spalten nicht zur Ablösung von Partikeln kommt. Vielmehr kann Stahl auch im Trockenverfahren rückstandsfrei gespalten werden.

Anders dagegen beim Spalten von Aluminiumband: Hier finden sog. Nassverfahren Anwendung, bei denen die Messer mit einer Flüssigkeit beaufschlagt werden. Dies hat seine Ursache in den weichen Materialeigenschaften von Aluminium. De Weichheit des Aluminiums führt dazu, dass beim Spalten von Aluminium Abrasionspartikel erzeugt werden, die als Kaltaufschweißungen am Werkzeug haften bleiben. Sie sind Folge der sich unter hoher Flächenpressung berührenden Messer und des Bandes. Die Berührflächen haften infolge Adhäsion aneinander. Beim Gleiten werden dann Randschichtteilchen abgeschert. Diese bleiben an der Gleitfläche der Messer haften. Dieser Verschleißmechanismus wird als "adhäsiver Verschleiß" bezeichnet. Die am Messer anhaftenden Partikel führen beim weiteren Spalten zu einer Beschädigung des Bandes. Zur Vermeidung dieses Phänomens werden die Nassverfahren eingesetzt.

Als Schmierstoffe kommen beim Spalten von Aluminium sowohl Öle als auch Ethanol-Mischungen und Emulsionen zum Einsatz. Durch die Schmierstoffe wird eine hydro-statische Trennung zwischen dem Messer und dem Aluminiumband erzeugt. Die Verwendung von Ethanol-Mischungen weist dabei den Vorteil auf, dass sich diese nach kurzer Zeit weitestgehend verflüchtigen und folglich kaum Rückstände auf dem Spaltband zurück bleiben. Man spricht in diesem Zusammenhang von einem "quasi trockenen" Verfahren.

Auch bei Anwendung des quasi trockenen Verfahrens findet durch die Verwendung des Schmiermittels eine Veränderung der Eigenschaften des Bandes statt, beispielsweise eine Beeinflussung der bereits vor dem Spalten vorgesehenen Konservierung. Aber auch auf die nachfolgende Behandlung des Spaltbandes hat das Schmiermittel Auswirkungen, da die seitens des Abnehmers gemachten Vorgaben für das Band nicht vollständig eingehalten werden können, weil das Band mit dem Schmiermittel verunreinigt ist. Folglich entsprechen mit Schmiermitteln gespaltene Aluminiumbänder in der Regel nicht exakt den Vorgaben der Kunden. Auch wird das Recycling von Aluminiumband durch Schmiermittelrückstände negativ beeinflusst. Hinzu kommt, dass der zu betreibende technische Aufwand für die Erstellung und den Betrieb von Spaltanlagen, die nach dem Nassverfahren arbeiten, erheblich viel größer ist, als bei nach dem Trockenverfahren arbeitenden Anlagen.

Vor dem beschriebenen Hintergrund liegt der vorliegenden Erfindung die Aufgabe zugrunde, ein Werkzeug zum Spalten von Aluminiumband zu schaffen, das ohne Verwendung von Schmiermitteln einsetzbar ist und dennoch einen adhäsiven Verschleiß vermeidet. Gemäß der Erfindung wird diese Aufgabe dadurch gelöst, dass auf den Edelstahl eine reibungsmindernde Beschichtung aufgebracht ist.

Mit der Erfindung ist ein Werkzeug zum Spalten von Aluminiumband geschaffen, welches ohne Verwendung von Schmiermitteln beim Spalten von Aluminiumband einsetzbar ist und dabei einen adhäsiven Verschleiß vermeidet. Mit dem erfindungsgemäßen Werkzeug ist daher die Herstellung von Aluminiumspaltband möglich, welches nicht durch die im Stand der Technik verwendeten Schmiermittel kontaminiert ist. Folglich können die Kundenvorgaben bezüglich des Aluminiumspaltbandes genau eingehalten werden.

In Weiterbildung der Erfindung ist die Beschichtung eine metallhaltige, kohlenstoffbasierte, amorphe Schicht. Die gewählte Beschichtung weist eine hohe Härte bei gleichzeitig niedrigem Reibungskoeffizienten auf. Zudem hat die Beschichtung einen sehr dichten und glatten Schichtaufbau und ist biokompatibel.

Vorteilhaft weist die Beschichtung eine Dicke zwischen 1 und 5 µm, vorzugsweise 2 µm auf. Es hat sich herausgestellt, dass diese Schichtdicken ausreichend sind, um eine zuverlässige und dauerhafte reibungsmindernde Beschichtung hervorzurufen.

Die Aufgabe wird zudem durch ein Verfahren zur Herstellung eines Werkzeugs zum Spalten von Aluminiumband, bei dem zunächst ein Ring aus einem Edelstahl hergestellt wird, der wärmebehandelt und anschließend poliert wird und auf den dann eine reibungsmindernde Beschichtung aufgebracht wird.

Bevorzugt wird die Beschichtung mittels physikalischer Gasphasenabscheidung aufgebracht. Verfahren zur physikalischen Gasphasenabscheidung, kurz PVD-Verfahren (PVD = physical vapour deposition), welches zu den vakuumbasierten Beschichtungsverfahren bzw. Dünnschichttechnologien zählt. Damit wird eine ausgezeichnete Haftfestigkeit ohne Härteverlust oder Verzug des Grundwerkstoffes erzielt. Zudem kann mit diesem Verfahren eine sehr hohe Härte erzielt werden.

In Ausgestaltung der Erfindung wird der Ring mit diamantbasierten Polierpasten poliert. Durch das Polieren werden Rauheiten mit einer mittleren Rautiefe von weniger als 0,03 erzielt.

Andere Weiterbildungen und Ausgestaltungen der Erfindung sind in den übrigen Unteransprüchen angegeben. Ein Ausführungsbeispiel der Erfindung ist in der Zeichnung dargestellt und wird nachfolgend im Einzelnen beschrieben. Es zeigen:

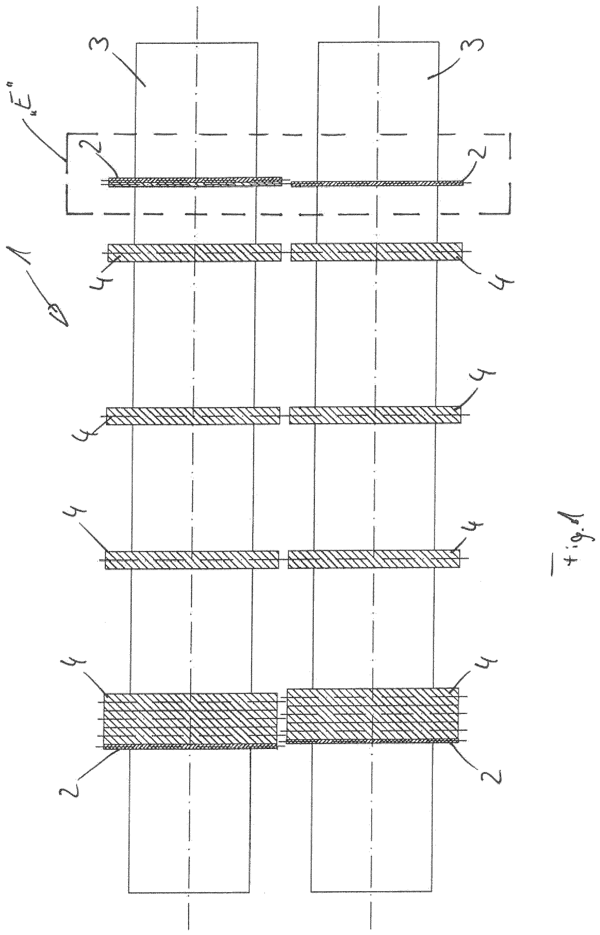

- Figur 1: die schematische Anordnung einer Schneideinheit und

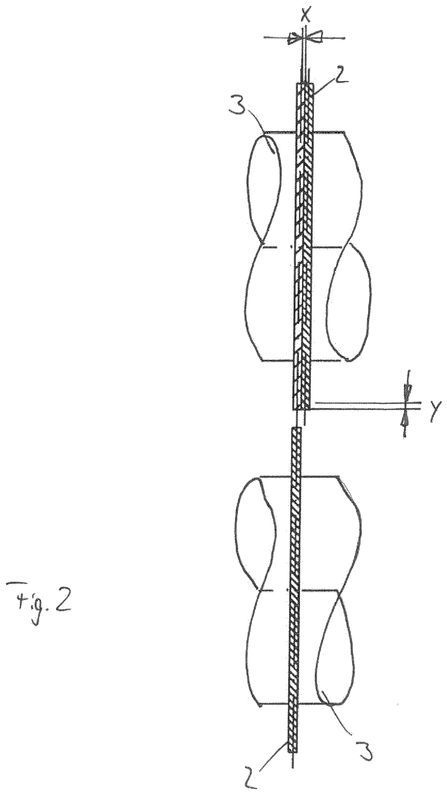

- Figur 2: die vergrößert dargestellte Einzelheit "E" in Figur 1.

Werkzeuge zum Spalten von Aluminiumband werden in Spaltanlagen verwendet. Bei solchen Spaltanlagen handelt es sich um Maschinen für das vollautomatische Spalten von Bändern. Sie bestehen im Wesentlichen aus einer Abwickelhaspel, auf der das aufgewickelte Aluminiumband, das sog. Coil, abwickelbar angeordnet ist. Das abgewickelte Band durchläuft dabei die Längsteilanlage selbst. Diese umfasst in der Regel einen Bandeinlauf, eine Transportwalzensektion, eine Richtanlage und eine Schneideinheit 1, in der sich rotierende Werkzeuge 2 zum Spalten, also die Messer, befinden. Die Spaltanlagen umfassen weiterhin eine Aufwickelhaspel mit der das gespaltene Aluminiumband zu mehreren Coils geringerer Breite aufgewickelt wird. Zudem sind vor und hinter der Spaltanlage Coil-Drehkreuze und Vorrichtungen zur Bestückung bzw. Entnahme der Coils angeordnet.

Das Werkzeug 2 (Messer) zum Spalten von Aluminiumband hat eine ringförmige Gestalt und besteht aus einem Edelstahl. Vorzugsweise kommt ein pulvermetallurgisch hergestellter Schnell- oder Kaltarbeitsstahl zur Anwendung, der hochverschleißfest ist, eine hohe Zähigkeit und eine sehr gute Maßbeständigkeit bei der Wärmebehandlung aufweist, wie dies beispielsweise bei der Sorte K490 (PM23) der Fall ist. Zudem ist der bevorzugte Stahl sehr gut zerspanbar und schleifbar. Alternativ kann auch ein Chromstahl der Sorte K110 (1.2379) zum Einsatz kommen. Dabei handelt es sich um einen Chromstahl mit sehr hohem Widerstand gegen abrasiven und adhäsiven Verschleiß. Auch dieser Stahl verfügt über eine gute Zähigkeit, ist maßänderungsarm und hat eine hohe Druckfestigkeit.

Das Werkzeug 2 ist poliert. Der Poliervorgang erfolgt nach der Wärmebehandlung, mit der das Werkzeug die erforderliche Härte erhält, und nach der Maßbearbeitung. Nach dem Polieren weist das Werkzeug 2 aus K490 (PM23) eine Oberfläche mit einem Mittenrauwert Rₐ<0,03 auf, und zwar sowohl in als auch quer zur Werkzeugachse gemessen. Der genannte Mittenrauwert entspricht Spiegelglanz. Bei Verwendung der Sorte K110 (1.2379) lassen sich nicht ganz so gute Rauwerte erzielen, da der Werkstoff K490 (PM23) über bessere Poliereigenschaften verfügt. Zum Polieren kommen diamantbasierte Polierpasten zur Anwendung. Das Polieren kann manuell oder maschinell erfolgen.

Auf den polierten Edelstahl des Werkzeugs 2 ist eine reibungsmindernde Beschichtung aufgebracht. Die Beschichtung ist im Ausführungsbeispiel eine metallhaltige, kohlenstoffbasierte, amorphe Schicht. Die Beschichtung weist eine Dicke zwischen 1 und 5 µm auf. Im Ausführungsbeispiel hat sie eine Dicke von 2 µm.

Bei der Herstellung des erfindungsgemäßen Werkzeugs 2 zum Spalten von Aluminiumband wird zunächst ein Ring aus einem Edelstahl hergestellt, bei dem es sich vorzugsweise um die oben genannten Sorten handelt. Der Ring wird dann wärmebehandelt, um die gewünschte Härte zu erzielen. Anschließend wird der Ring maßbearbeitet, was mittels spanender Fertigungsverfahren, wie beispielsweise Drehen, Schleifen o. dgl. erfolgen kann. Im Anschluss wird das so bearbeitete Werkzeug poliert, was vorzugsweise mittels diamantbasierten Polierpasten erfolgt.

Auf den so bearbeiteten Edelstahlring wird eine reibungsmindernde Beschichtung aufgebracht. Bei der Beschichtung handelt es sich um einen sogenannte DLC- oder Diamond-Like-Carbon-Schicht. Diese Schichten haben hervorragende Anti-Adhäsionseigenschaften. Im Ausführungsbeispiel kommt eine metallhaltige, kohlenstoffbasierte, amorphe Schicht zum Einsatz. Die Beschichtung wird in einer Dicke zwischen 1 und 5 µm aufgebracht, vorzugsweise in einer Dicke von 2 µm.

Die Beschichtung wird mittels physikalischer Gasphasenabscheidung, dem sogenannten PVD-Verfahren (Pysical Vapour Deposition), aufgebracht. PVD-Verfahren bezeichnen eine Gruppe von vakuumbasierten Beschichtungsverfahren bzw. Dünnschichttechnologien, bei denen die Schicht direkt durch Kondensation eines Materialdampfes des Ausgangsmaterials gebildet wird. Bei diesem Verfahren wird ein Dampf aus den schichtbildenden Teilchen erzeugt, der dann in einem Vakuum zum Substrat, varliegend dem Werkzeug, transportiert wird. Der Dampf kondensiert auf dem Werkzeug aus und bildet die gewünschte Schicht aus. Die Behandlung erfolgt bei relativ geringen Temperaturen von ca. 200°C. Das erfindungsgemäß gewählte Beschichtungsverfahren hat sich auch im Zusammenspiel mit den Messerwerkstoffen K110 (1.2379) und K490 (PM 23) bewährt, da diese durch ihre hohe Härte und ihr regelmäßiges Gefüge für die PVD-Beschichtung besonders geeignet sind.

Die so hergestellten Werkzeuge 2 werden auf Wellen 3 angeordnet, die in einem - nicht dargestellten - Gerüst vorgesehen sind. Auf den Wellen 3 sind darüber hinaus ringförmige Gummis 4 angeordnet, die einerseits zum Transport des Bandes im Bereich der Schneideinheit 1 dienen, andererseits ein Durchbiegen des zu spaltenden Bandes zwischen den Werkzeugen 2 verhindern.

Bei den mit den erfindungsgemäß gestalteten Werkzeugen 2 durchgeführten Versuchen wurden bei einer gewählten Schnittluft "x", also dem zwischen den Werkzeugen 2 in horizontaler Richtung gewählten Abstand von 5% der zu schneidenden Aluminiumbanddicke von 2mm, im Ausführungsbeispiel also ein Abstand von 0,1mm, und einer Überlappung "y", also dem vertikalen Abstand der Werkzeuge von 0,08mm bei der Banddicke von 2mm die besten Ergebnisse erzielt. Es konnten bei den Versuchen auch unter mikroskopischer Betrachtung der Werkzeuge keine Aluminiumkaltaufschweißungen festgestellt werden. Zwar war ein sichtbarer, silber-farbener Schleier auf den Messern erkennbar. Dieser war jedoch mit 0,1 molarer Natronlauge innerhalb von wenigen Sekunden nach dem Auftrag vollständig beseitigt. Äußere Beschädigungen der Werkzeuge waren ebenfalls nicht feststellbar. Auch die aufgebrachte Beschichtung blieb vollständig intakt.

## Patentansprüche

1. Werkzeug zum Spalten von Aluminiumband, welches eine ringförmige Gestalt hat und aus einem Edelstahl besteht, der poliert ist, **dadurch gekennzeichnet, dass** auf den Edelstahl eine reibungsmindernde Beschichtung aufgebracht ist.

2. Werkzeug nach Anspruch 1, **dadurch gekennzeichnet, dass** die Beschichtung eine metallhaltige, kohlenstoffbasierte, amorphe Schicht ist.

3. Werkzeug nach Anspruch 1 oder 2, **dadurch gekennzeichnet, dass** die Beschichtung eine Dicke zwischen 1 und 5 µm, vorzugsweise 2 µm aufweist.

4. Verfahren zur Herstellung eines Werkzeugs zum Spalten von Aluminiumband, bei dem zunächst ein Ring aus einem Edelstahl hergestellt wird, der wärmebehandelt, anschließend maßbearbeitet und danach poliert wird, **dadurch gekennzeichnet, dass** auf den so bearbeiteten Edelstahl eine reibungsmindernde Beschichtung aufgebracht wird.

5. Verfahren nach Anspruch 4, **dadurch gekennzeichnet, dass** die Beschichtung mittels physikalischer Gasphasenabscheidung aufgebracht wird.

6. Verfahren nach Anspruch 4 oder 5, **dadurch gekennzeichnet, dass** der Ring mit diamantbasierten Polierpasten poliert wird.
